(19) Europäisches Patentamt
European Patent Office
Office européen des brevets

(11) **EP 3 227 696 B1**

(12) **FASCICULE DE BREVET EUROPEEN**

(45) Date de publication et mention de la délivrance du brevet:
**25.07.2018 Bulletin 2018/30**

(51) Int Cl.:
***G01R 31/00*** *(2006.01)*

(21) Numéro de dépôt: **15801859.8**

(22) Date de dépôt: **30.11.2015**

(86) Numéro de dépôt international:
**PCT/EP2015/078074**

(87) Numéro de publication internationale:
**WO 2016/087378 (09.06.2016 Gazette 2016/23)**

(54) **PROCÉDÉ ET ENSEMBLE DE LOCALISATION DE DÉCHARGES ÉLECTROSTATIQUES SUR AÉRONEF EN VOL**

VERFAHREN UND ANORDNUNG ZUR ORTUNG ELEKTROSTATISCHER ENTLADUNGEN BEI EINEM FLUGZEUG IM FLUG

METHOD AND ASSEMBLY FOR LOCATING ELECTROSTATIC DISCHARGES ON AIRCRAFT IN FLIGHT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.12.2014 FR 1461707**

(43) Date de publication de la demande:
**11.10.2017 Bulletin 2017/41**

(73) Titulaire: **AIRBUS (SAS)**
**31700 Blagnac (FR)**

(72) Inventeurs:
• **REVEL, Ivan**
**31520 Ramonville (FR)**
• **PERES, Gilles**
**31000 Toulouse (FR)**

(74) Mandataire: **Gicquel, Olivier Yves Gérard et al**
**Airbus Operations S.A.S.**
**Département Propriété Intellectuelle**
**ETRT - M0101/1**
**316, route de Bayonne**
**31060 Toulouse (FR)**

(56) Documents cités:
**US-A- 5 923 160        US-A- 6 064 340**
**US-A1- 2003 071 628      US-H- 536**

• **Juan De La Cierva ET AL: "THEORETICAL ANALYSIS OF AIRCRAFT ELECTROSTATIC DISCHARGE", USAAVLABS TECHNICAL REPORT 65-53, 31 août 1965 (1965-08-31), pages 1-119, XP055219612, Extrait de l'Internet: URL:http://www.dtic.mil/dtic/tr/fulltext/u 2/621521.pdf [extrait le 2015-10-09]**

EP 3 227 696 B1

**Description**

La présente invention appartient au domaine des aéronefs et des phénomènes de décharges électrostatiques qui se produisent sur les aéronefs en vol.

Plus particulièrement, l'invention concerne un procédé et un dispositif pour détecter et localiser l'emplacement sur la structure d'un aéronef en vol où s'est produite une décharge électrostatique.

Il est bien connu que le frottement des particules présentes dans l'air sur la structure d'un aéronef produit dans certaines circonstances des accumulations de charges électriques.

Lorsque ces accumulations deviennent suffisantes pour que localement le champ électrique dépasse le seuil de claquage, il se produit une décharge électrostatique.

Ces décharges restent en général de faible intensité à l'échelle d'un aéronef et sont sans danger pour la structure, mais elles produisent cependant des rayonnements électromagnétiques suffisamment intenses pour perturber le fonctionnement de certains équipements de l'aéronef, en particulier les équipements radioélectriques.

Historiquement ce phénomène a été observé et étudié en détail dans les années 1960 à une époque où les structures des avions de ligne étaient essentiellement métalliques.

Il avait conduit à la mise au point des déperditeurs de potentiels qui assurent en continu la dispersion dans l'air des charges électriques ayant tendance à s'accumuler en vol sur la structure.

Cette solution s'est avérée satisfaisante tant que les structures des avions étaient principalement métalliques et conductrices électriquement.

Cependant, les problèmes liés aux décharges électrostatiques sont réapparus de manières critiques avec l'introduction progressive des matériaux composites isolants ou faiblement conducteurs dans les structures des aéronefs.

Dans le cas de ces matériaux isolants ou faiblement conducteurs, il est mis en place des métallisations de surface et des tresses de continuité électrique pour que les charges puissent s'écouler et finalement être dispersées par les dispositifs connus.

Le document «Theoretical analysis of aircraft électrostatique discharge», USAAVLABS Technical reports traite de l'analyse de décharges électrostatiques sur les aéronefs, notamment des charges corona et propose un dispositif pour les évacuer.

Cependant, il est observé sur les avions modernes comportant de nombreux éléments de structure en matériaux composites que les décharges électrostatiques sont de plus en plus fréquentes.

Lorsque ces décharges deviennent perturbantes pour les systèmes, il est nécessaire d'en rechercher l'origine, généralement un défaut localisé de métallisation ou de continuité électrique de la structure, pour en éliminer la source.

Une telle recherche s'avère fastidieuse du fait qu'il n'y a généralement aucun indice visible d'un emplacement où aurait pu se produire une décharge électrique dont les effets ont été signalés par un équipage. Il en résulte une recherche à l'aveugle qui conduit à des immobilisations longues de l'aéronef concerné et qui amène à prendre des mesures correctives sans certitude de leurs pertinences et qui souvent n'apportent pas la solution au problème constaté.

Différentes solutions ont été proposées à ce respect, le brevet US 2003/0071628 propose un capteur de champ électrostatique situé près d'une aire d'atterrissage pour mesurer le champ électrostatique d'un aéronef lors de son atterrissage et d'identifier la charge électrique pour des raisons de sécurité des personnes. Néanmoins, cette solution ne permet pas de localiser l'emplacement d'une décharge électrostatique.

Les brevets US H536 et US5,923,160 donnent des exemples de dispositifs pour localiser de manière basique une décharge électrostatique sur une structure au moyen d'un ou plusieurs capteurs situés sur sa surface. Pour localiser la décharge électrostatique ces documents proposent différentes corrélations entre la durée et intensité de signaux reçus et l'emplacement des capteurs.

Le brevet US 6,064,340 divulgue en particulier un système et procédé pour déterminer les emplacements de décharges électrostatiques dans un volume surveillé par des récepteurs des signaux électromagnétiques, la localisation de la source de rayonnement résultant d'un calcul géométrique d'intersections hyperboloïdes. Cette solution s'avère néanmoins insuffisante pour la localisation des décharges électrostatiques sur une surface complexe telle que la surface extérieure d'un aéronef.

La présente invention apporte une solution spécifique à ce problème en donnant à un opérateur de maintenance les moyens de localiser sur une structure d'aéronef l'emplacement d'une décharge électrostatique avec une précision suffisante pour lui permettre de mener une investigation rapide du phénomène et de l'identification de ses causes.

L'invention concerne un procédé de localisation de décharges électrostatiques apparues sur un aéronef en vol, comme défini par la revendication 1. Le procédé permet ainsi à un opérateur de maintenance de localiser une zone d'investigation réduite, limitant le nombre d'hypothèses qu'il doit envisager dans les cas d'une recherche dans des zones non circonscrites de l'aéronef, ce qui permet un gain de temps important sur l'immobilisation de l'aéronef pour traiter le problème observé, l'immobilisation pouvant être réduite de plusieurs jours à quelques heures avec le bénéfice du procédé de l'invention. Grâce au procédé, il est également assuré que les opérateurs de maintenance pourront appliquer rapidement les mesures correctives adaptées, alors qu'en absence de localisation limitée de la zone des décharges électrostatiques ils seront conduits dans la plupart des cas à réaliser des réparations sans avoir la certitude de les appliquer à l'emplacement idoine.

Dans une forme de mise en oeuvre du procédé, l'étape d'enregistrement comporte une étape d'échantillonnage des signaux reçus par chaque détecteur **Di** et de datation des dits signaux par rapport à une base de temps commune à l'ensemble des détecteurs.

Ainsi conditionnés les signaux enregistrés sont prêts à être exploités dans une chaîne de traitement numérique ultérieure.

Dans une forme de réalisation, les signaux échantillonnés et datés sont enregistrés dans une mémoire permanente d'un système d'enregistrement embarqué de l'aéronef.

Les signaux sont alors disponibles pour un traitement différé et il est ainsi évité de mettre en oeuvre des moyens de traitement en temps réel relativement puissants et qui devraient être embarqués dans l'aéronef.

Avantageusement, l'étape d'analyse comporte une sous-étape de regroupement des enregistrements des détecteurs Di par événements, un événement correspondant à une décharge électrostatique pendant le vol de l'aéronef.

Ainsi, chaque événement, correspondant à une décharge électrostatique, peut être traité unitairement et il est évité des risques de confusion dans le traitement des signaux entre des événements voisins différents.

Suivant l'invention, l'étape d'analyse applique aux enregistrements des détecteurs correspondant à un même événement des algorithmes de propagation inverse des ondes électromagnétiques pour déterminer la zone sur la surface extérieure de l'aéronef où s'est probablement produite la décharge électrostatique à l'origine des dites ondes électromagnétiques.

Il est ainsi déterminé compte tenu d'un modèle de la structure de l'aéronef une zone localisant la décharge électrostatique sans mettre en oeuvre de simulation amont dans le procédé.

Suivant l'invention, l'étape d'analyse compare des données des enregistrements, correspondant à un même événement, à des données simulées par des algorithmes de propagation directe des ondes électromagnétiques, appliqués à des sources d'émission électromagnétique d'emplacements choisis sur la structure de l'aéronef, pour déterminer par comparaison la zone sur la surface extérieure de l'aéronef où s'est probablement produite la décharge électrostatique à l'origine des dits signaux électromagnétiques.

Bien que mettant en oeuvre des calculs intermédiaires, voire un processus itératif, ce mode présente l'avantage de mettre en oeuvre des simulations de propagation directe pour lesquelles les algorithmes connus sont plus rapides et donnent de meilleurs résultats.

Dans une forme de mise en oeuvre, des caractéristiques des enregistrements des détecteurs **Di** correspondant à un même événement sont comparées aux effets, mesurés ou calculés, d'une onde électromagnétique émise par chacun des points d'un maillage de la surface extérieure de la structure de l'aéronef et dans lequel la zone est définie par un sous-ensemble des points du maillage dont des caractéristiques sont les moins distantes des caractéristiques du signal mesuré.

Dans ce mode, les calculs de simulation, en pratique relativement long à réaliser, ne sont effectués qu'une seule fois par type d'aéronef et l'identification d'un point ou d'un nombre de points limité pour localiser l'événement est réalisée par comparaison et par des calculs simples conduisant à des résultats rapides.

Dans une forme de mise en oeuvre, il est mis en oeuvre une étape préalable de création d'une base de données de référence, dans laquelle base de données de référence les caractéristiques des signaux reçus par chacun des détecteurs Di sont définies pour chacun des points du maillage considéré comme source d'émission d'une onde électromagnétique.

La base de données de référence est avantageusement utilisée lors de l'étape d'analyse pour identifier rapidement les points du maillage dont les effets simulés sur les détecteurs sont les plus voisins de ceux enregistrés pour un événement.

Les avantages d'une telle solution ressorte de manière évidente lorsqu'il est considéré que, avec des moyens de calculs ordinaires, la construction de la base de données de référence nécessite environ 6 jours et que la localisation des points pour déterminer la zone recherchée est pratiquement instantanée, tout au plus quelques minutes suivant les caractéristiques du maillage.

Suivant un mode de mise en oeuvre du procédé de l'invention, le procédé comporte avantageusement une étape d'identification sous forme graphique et ou numérique de la zone sur la surface extérieure de l'aéronef.

Ainsi un opérateur identifie rapidement sur l'aéronef la zone qu'il doit inspecter.

L'invention concerne également un ensemble pour localiser sur une structure d'un aéronef, conformément au procédé, au moins une décharge électrostatique apparue en vol, comme défini par la revendication 10. Dans une forme de réalisation, le système d'enregistrement comporte des moyens, physiques ou logiques, de synchronisation des dates attribuées aux signaux reçus par les détecteurs, les dits moyens de synchronisation compensant des différences de durée de transmission des signaux entre les détecteurs et des moyens d'enregistrement.

Il est ainsi pris en compte au moment de l'enregistrement des événements les temps de transmission des signaux entre les détecteurs et les moyens d'enregistrement correspondant à ceux de l'aéronef sur lequel est effectué l'enregistrement, et ainsi évité de corriger ces temps de transmission au niveau du système d'analyse qui sinon devrait tenir compte des différences existantes entre des avions du même type.

Dans une forme avantageuse de réalisation, au moins un détecteur met en oeuvre une antenne hertzienne de l'aéronef à laquelle est adjoint un coupleur d'antenne raccordé d'une part à un câble d'antenne destiné à un équipement de l'aéronef, pour lequel est installée ladite antenne, et d'autre part à un support de transmission raccordé au moyen d'enregistrement.

Il est ainsi évité d'installer des détecteurs spécifiques, ou pour le moins d'en limiter le nombre, avec les conséquences techniques et économiques sur la structure et la définition de l'aéronef de l'installation de nouveaux détecteurs.

Avantageusement si un nombre et un agencement des antennes existantes de l'aéronef sont adaptés aux besoins du système d'enregistrement, il n'est pas nécessaire d'installer de détecteur supplémentaire.

Dans une forme de réalisation, le système d'enregistrement comporte des moyens de liaison numérique de transfert de données avec une installation sol pour transférer les données enregistrées par ledit système d'enregistrement vers le système d'analyse.

Ainsi le transfert des données vers un atelier pour analyser les données enregistrées peut être réalisé sans intervention sur l'avion. D'après l'invention, les moyens de traitement des signaux du système d'analyse comportent un simulateur incorporant des algorithmes de propagation inverse des ondes électromagnétiques et applique les dits algorithmes de propagation inverse aux signaux, reçus par les détecteurs **Di** et correspondant à un même événement, pour localiser une zone, sur la surface extérieure de la structure de l'aéronef, dont les dits signaux émis par une décharge électrostatique sont issus. D'après l'invention, les moyens de traitement des signaux comportent un simulateur incorporant des algorithmes de propagation directe des ondes électromagnétiques et applique les dits algorithmes pour déterminer, par comparaison entre des données enregistrées, correspondant aux signaux reçus par les détecteurs **Di** et correspondant à un même événement, et des données simulées, une zone, sur la surface extérieure de la structure de l'aéronef, dont les signaux émis par une décharge électrostatique sont issus.

Dans un mode de réalisation, l'ensemble comporte un premier système de construction d'une base de données de référence, ledit premier système comportant un modèle numérique de la structure de l'aéronef, sur une surface extérieure duquel aéronef est défini un maillage déterminant des origines arbitraires d'ondes électromagnétiques, ledit premier système comportant un simulateur incorporant les algorithmes de propagation directe des ondes électromagnétiques, la base de données de référence comportant pour chaque origine **Op** définie par le maillage au moins une information de position de ladite origine sur la surface extérieure de la structure de l'aéronef et des caractéristiques calculées de temps et ou de forme de chacun des signaux reçus par chacun des détecteurs **Di** suite à une émission simulée d'une onde électromagnétique à l'emplacement de ladite origine.

Suivant une application principale de l'invention, l'ensemble tel que décrit précédemment comporte en outre un aéronef dans lequel est installé le système d'enregistrement des signaux électromagnétiques émis par des décharges électrostatiques sur ledit avion.

Avantageusement, des antennes de réception de radiocommunication et ou de radionavigation de l'aéronef sont également utilisées comme détecteurs Di du système d'enregistrement.

La description détaillée d'un procédé et d'exemples de réalisation de l'invention est faite en référence aux figures qui représentent schématiquement :

Figure 1 : une présentation globale du procédé suivant une forme de réalisation de l'invention mettant en oeuvre trois étapes principales ;

Figure 2 : une présentation de la première étape du procédé de la figure 1 pour la création d'une base de donnée de référence ;

Figure 3 : une présentation de la deuxième étape du procédé au cours de laquelle les données relatives à des décharges électrostatiques sont enregistrées au cours du vol de l'aéronef ;

figure 4 : une représentation de la troisième étape du procédé de la figure 1 aboutissant par le traitement des données enregistrées lors de la deuxième étape à la localisation sur la structure de l'aéronef de l'emplacement de la décharge électrostatique ;

figure 5 : une illustration schématique des effets d'une décharge électrostatiques sur un aéronef :

figure 6a : une illustration d'un aéronef comportant un système d'enregistrement des signaux provenant de décharges électrostatiques ;

figure 6b : un schéma d'un système d'enregistrement représenté sans l'aéronef ;

figure 7 : une représentation schématique du système d'analyse des signaux enregistrés par laquelle il est identifié la zone de l'avion dans laquelle s'est produit la décharge électrostatique.

Sur les figures des éléments similaires sont repérés par des repères identiques.

Sur les différentes vues il a été privilégié le côté illustratif du procédé et de l'ensemble mettant en oeuvre le procédé et les échelles entre les différents éléments représentés ne sont pas respectées.

Les phénomènes par lesquels des charges électriques s'accumulent sur des parties d'un aéronef et établissent entre différentes parties de la structure des différences de potentiels ou renforcements locaux de champ électrique à l'origine de décharges électrostatiques sont bien connus et ne seront pas décrits en détail ici.

Les charges apparaissent à l'extérieur de l'aéronef, dans certaines conditions de vol, par effet triboélectrique lors du frottement des particules présentes dans l'air sur la structure de l'aéronef et s'accumulent dans des zones, lorsqu'elles ne sont pas évacuées naturellement, jusqu'à ce que les différences de potentiel des parties chargées différemment soient suffisantes pour produire une décharge électrostatique.

Les décharges électrostatiques peuvent également se produire dans des zones de l'aéronef d'accumulation naturel des charges électriques, en particulier les extrémités conductrices dudit aéronef dans lesquelles le champ électrique est localement renforcé. Dans ces zone, en particulier si elles ne sont pas pourvues de déperditeurs de potentiel, le champ électrique local peut dépasser une valeur de claquage.

Suivant des techniques connues, les phénomènes de décharge électrostatique en vol sont évités en assurant à la structure de l'aéronef d'être équipotentielle et en évacuant les charges électrostatiques dans l'atmosphère le plus tôt possible pour limiter les différences de potentiel et éviter des émissions électromagnétiques intenses que produisent des décharges en cas de fortes différences de potentiel ou impliquant des charges électriques importantes. L'évacuation des charges électrostatiques dans l'air est généralement assurée par des déperditeurs de potentiel fixés à la structure de l'aéronef dans des zones vers lesquelles les charges électriques ont une tendance naturelle à s'accumuler, en particulier les extrémités de voilure ou autre surface portante, par effet de pointe.

Un aéronef moderne peut comporter des milliers de pièces de structures assemblées entre elles et la continuité électrique entre toutes ces pièces, malgré les précautions prises, n'est pas toujours garantie depuis la mise en service de l'aéronef jusqu'à sa fin de vie.

Les précautions prises sont le plus souvent des assemblages métal-métal au moyen de fixations conductrices électriquement, des liaisons articulées doublées par des tresses de métallisation, des pièces, non conductrices intrinsèquement, recouvertes de couches conductrices, par exemple des grillages de métallisation des matériaux composites.

Cependant, la présence de protections de surface sur les pièces et l'oxydation de certaines surfaces décapées conduit à l'apparition de défauts de liaisons équipotentielles qui sont difficiles et longues à identifier sur une structure d'aéronef assemblée.

La présente invention n'a pas pour but d'identifier le type de défaut pouvant conduire à une décharge électrostatique ni à définir une solution pour remédier à l'occurrence de décharges mais elle a pour objectif de localiser l'emplacement d'une décharge électrostatique constatée en vol par ses effets, de sorte qu'un opérateur de maintenance au sol effectue une recherche de défauts sur une zone réduite pour identifier le défaut à l'origine de la décharge constatée de manière très probable et puisse ainsi appliquer efficacement les mesures correctives pour remédier au défaut, en général un défaut de continuité électrique.

Suivant l'invention il est procédé à la localisation sur une structure d'un aéronef d'au moins une décharge électrostatique.

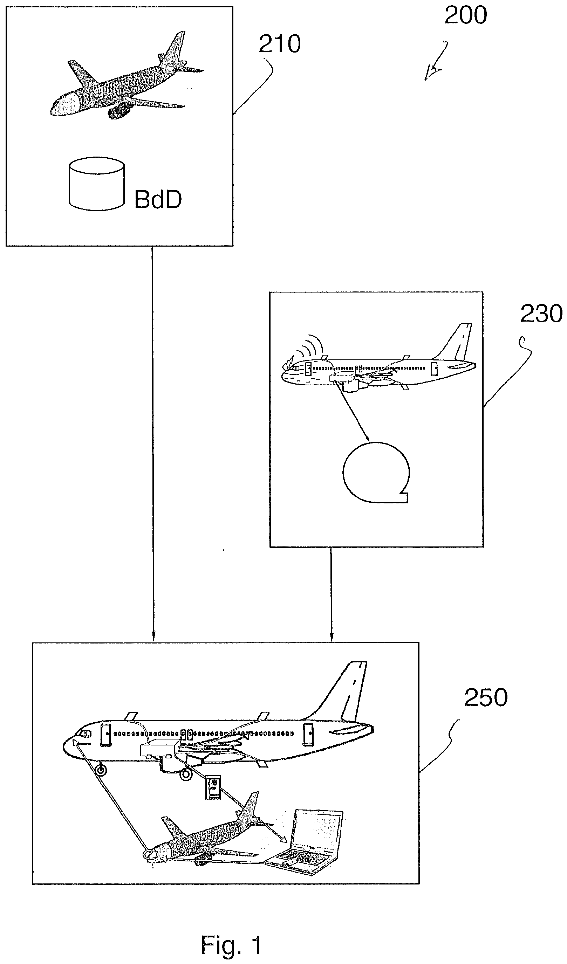

Le procédé 200, tel que schématisé sur le synoptique de la figure 1, comporte au moins trois étapes :

1/ une étape préalable 210 de caractérisation d'un aéronef ;
2/ une étape d'enregistrement 230 en vol des effets d'une ou plusieurs décharges électrostatiques sur des détecteurs agencés sur la structure de l'aéronef ;
3/ une étape d'analyse 250 des enregistrements et de traitement des dits enregistrements de sorte à obtenir une zone probable de localisation de chaque décharge enregistrée.

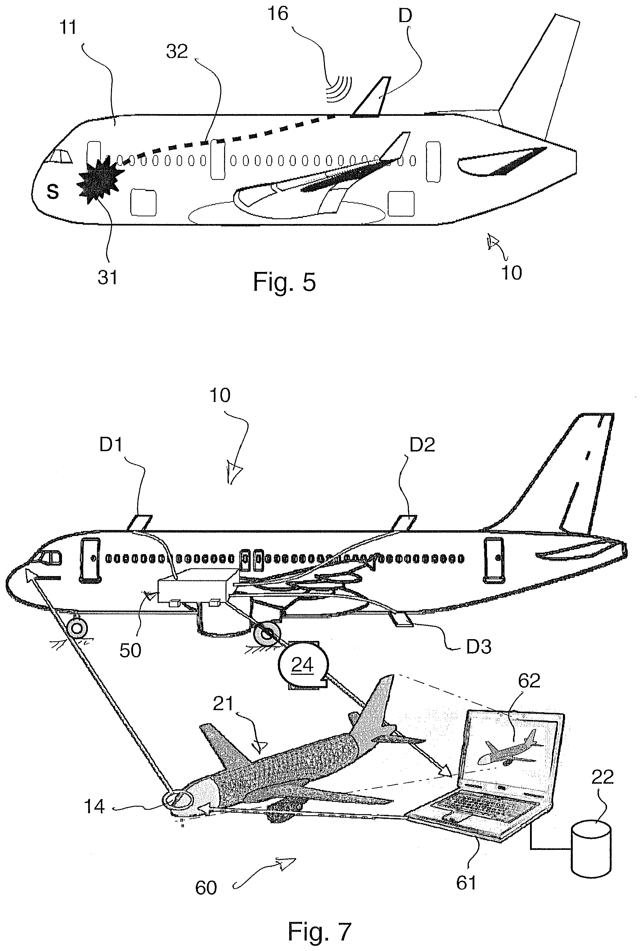

Le procédé utilise le phénomène physique, illustré sur la figure 5, dans lequel un signal électromagnétique 13, résultant dans ce cas d'une décharge électrostatique 31, se propage, dans un environnement donné, ici un aéronef 10, depuis une source **S** de ladite perturbation jusqu'à un détecteur **D,** de manière sensiblement constante.

Il en résulte que les trajets 32 suivis, les temps de propagation et les transformations (en particulier les atténuations) des signaux électromagnétiques entre la source **S** et le détecteur **D** sont reproductibles et prédictibles.

Cette constance découle directement des équations de Maxwell qui modélisent la propagation des ondes électromagnétiques et du fait que l'environnement de propagation, en particulier une structure 11 de l'aéronef 10 considéré, est inchangé.

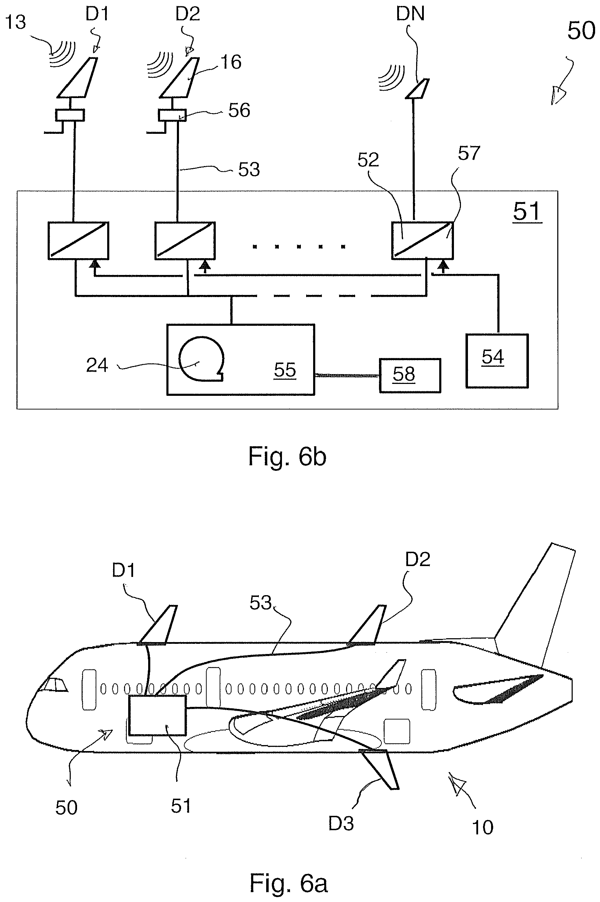

Pour localiser sur la structure 11 d'un aéronef 10, l'emplacement où s'est produite une décharge électrostatique, il est mis en oeuvre, comme illustré sur le schéma de principe de la figure 6a, une pluralité de détecteurs **Di** répartis sur la structure de l'aéronef, l'indice **i** variant de 1 jusqu'au nombre **N** de détecteurs mis en oeuvre.

Chaque détecteur **Di** est conçu pour détecter les champs électromagnétiques lui parvenant dans le domaine de fréquences et d'énergies attendues des décharges électrostatiques qui doivent être localisées.

Il doit être compris ici que les champs électromagnétiques pris en considération sont ceux dont les intensités sont suffisantes pour être perturbatrices des signaux utiles reçus par un aéronef, mais sont en pratique d'intensités bien inférieures à ceux résultant d'autres phénomènes violents comme des impacts de foudre sur la structure.

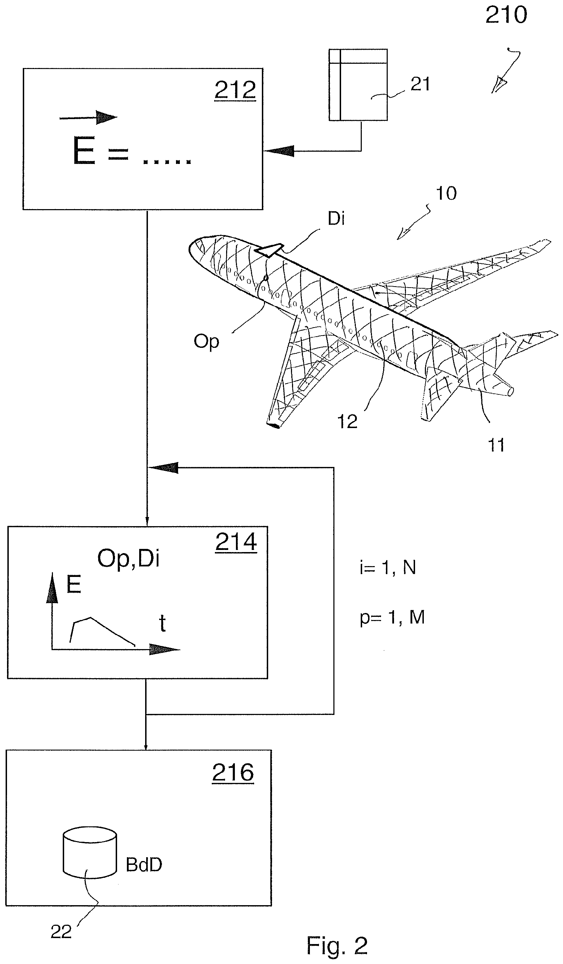

Dans l'étape préalable 210 de caractérisation de l'aéronef, illustrée sur le schéma de la figure 2, il est construit une base de données 22 de référence dont le contenu est établi par des signaux reçus par chacun des détecteurs **Di** pour une pluralité d'émissions électromagnétiques localisées en différentes origines **Op** déterminée sur la structure 11 de l'aéronef, l'indice **p** représentant un rang d'une origine donnée.

Les origines **Op** sont choisies pour former 212 un maillage 12 d'une surface extérieure de l'aéronef avec un pas choisi qui détermine en pratique une résolution du procédé de localisation d'une décharge électrostatique.

Le nombre d'origines **Op** peut être grand, **p** pouvant atteindre un nombre **M** pouvant dépasser plusieurs milliers, en pratique de 1000 à plus de 5000 suivant les dimensions de l'aéronef considéré, le procédé étant, au moins en théorie, d'autant plus précis que le maillage est serré comme il sera compris par la suite.

Considérant une décharge électrostatique en une origine **Op, p** appartenant à l'intervalle **[1, M],** connue du maillage, ladite décharge électrostatique produit sur chaque détecteur **Di** un signal caractéristique de ladite décharge et caractéristique de ladite origine.

Dans un mode de mise en oeuvre du procédé, il est considéré 214 le signal correspondant au champ électrique **E** en fonction du temps **t.**

Plus particulièrement il sera pris en compte dans la base de données 22 de référence un décalage temporel entre les signaux 13 reçus par les différents détecteurs pour une même émission électromagnétique.

Ainsi la base de données 22 de référence comporte, lorsqu'elle est constituée, une table d'origines **Op, p** allant de 1 à **M,** dans laquelle pour chaque origine sont définies :

- une position de l'origine **Op** sur la structure 11 de l'aéronef ;
- pour chaque détecteur **Di, i** = 1 à **N,** une forme du champ électromagnétique reçu en fonction du temps sur une échelle de temps commune à tous les détecteurs.

La position d'une origine **Op** du maillage 12 est identifiée dans la base de données 22 par tout moyen, de préférence sous forme numérique, permettant de localiser ledit emplacement sur la structure 11 de l'aéronef, par exemple un système de coordonnées ou un système de codes de zones.

La forme du signal électromagnétique simulé en une origine Op est avantageusement normée dans son intensité et dans son profil en fonction du temps pour les besoins du procédé, et est identique pour toutes les origines **Op.**

Cette étape préalable 210 de création de la base de données 22 est réalisée en principe une seule fois pour la mise en oeuvre du procédé et la base de données 22 de référence sera en principe commune pour la mise en oeuvre du procédé 200 de l'invention à tous les aéronefs d'un même modèle.

En effet, bien que des différences de détail, par exemple du fait de dispersions de fabrication, puissent exister dans les structures de deux aéronefs d'un même modèle, ces différences sont a priori minimes et peu susceptibles de changer le contenu de la base de données au point d'affecter la précision de localisation suivant le procédé au-delà de ce qui est attendu.

Bien que cette étape préalable 210 de caractérisation puisse être réalisée expérimentalement, il sera préféré réaliser la base de données 22 par calculs à partir d'un modèle numérique 21 de la structure de l'avion et en utilisant des algorithmes de résolution des équations de Maxwell.

En effet les moyens numériques de calculs actuels permettent de simuler de manière satisfaisante et avec des résultats relativement précis les caractéristiques en un point donné d'un champ électromagnétique ayant pour origine une source d'émission distante.

A contrario des mesures expérimentales pour une grille de plusieurs milliers de points seraient particulièrement fastidieuses et exigeraient des protocoles d'essais qui ne conduiraient pas nécessairement à une précision meilleure que par calculs, mais seraient certainement beaucoup plus coûteuses.

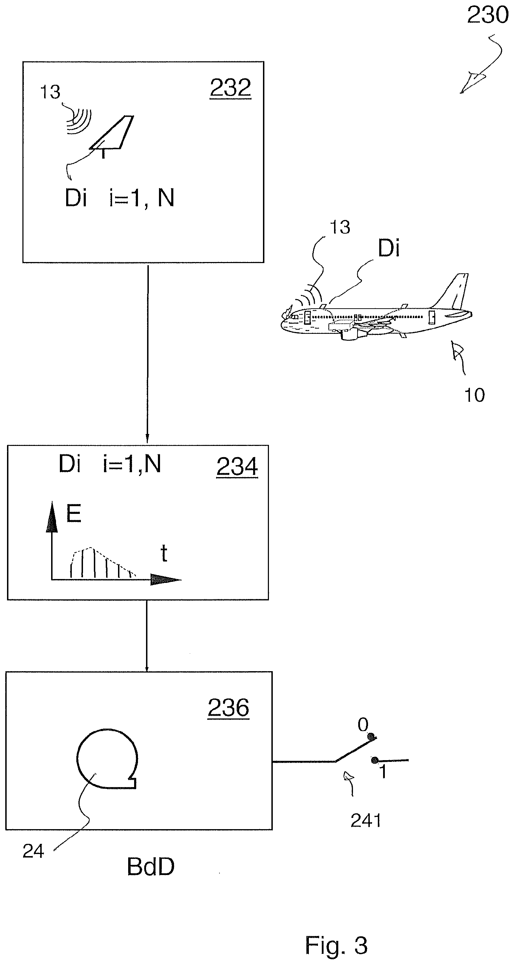

Dans l'étape d'enregistrement 230, illustrée sur le schéma de la figure 3, les signaux radioélectriques 13 reçus 232 par les différents détecteurs **Di** sont enregistrés.

Suivant des modes de fonctionnements variés, un enregistrement 24, peut être mis en service 241 automatiquement en continu lorsque l'aéronef est en vol, ou peut être commandé par un équipage lorsque celui-ci constate un niveau anormal de perturbations radioélectriques sur des systèmes de l'aéronef 10. En pratique ces deux modes sont compatibles et peuvent correspondre à des situations différentes.

Par exemple dans un vol ordinaire de l'aéronef, un mode d'enregistrements automatiques évite d'ajouter une charge de travail à l'équipage. A contrario, dans des conditions d'investigation au cours d'un vol d'essais ou de mise au point d'un aéronef, l'enregistrement peut être commandé et corrélé à d'autres événements observés.

Il est également possible de réaliser en vol des enregistrements en continu, lesdits enregistrements étant automatiquement analysés pendant le vol pour ne conserver que des périodes pendant lesquelles des niveaux d'activité électromagnétique suffisants pour correspondre à un risque de perturbations sont observés.

Lors de cette étape d'enregistrement 230, les signaux 13 reçus par chaque détecteur **Di** sont échantillonnés 234, numérisés et mémorisés 236 en étant synchronisés par rapport à une base de temps absolu.

Par synchronisation, il faut comprendre que chaque signal reçu par un détecteur est daté à la date à laquelle il est reçu par ledit détecteur.

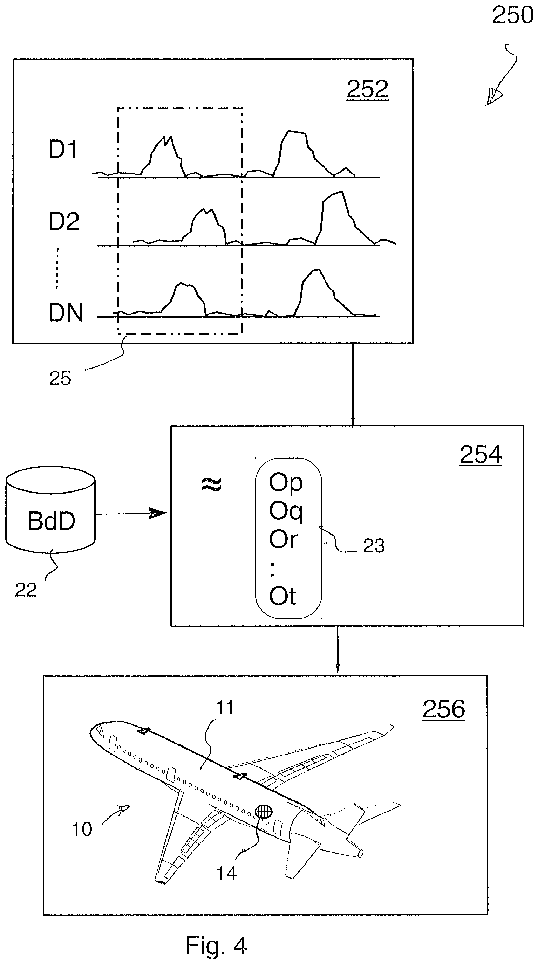

Lorsque des événements de décharges électrostatiques ont été signalés par un équipage ou sont simplement recherchés, les enregistrements 24 sont analysés au cours d'une étape d'analyse 250, illustrée sur le schéma de la figure 4.

Dans une première sous-étape 252 de regroupement, les enregistrements 24 des différents détecteurs **Di** sont regroupés par événements 25, c'est à-dire pour une même décharge électrostatique 31 génératrice d'un signal électromagnétique 13.

Il est ainsi, pour chaque événement 25, obtenu une série de N enregistrements élémentaires, N correspondant au nombre de détecteurs, comme illustré par le cadre en trait discontinu sur la figure 4 à l'étape 252 du procédé.

Les enregistrements des signaux de deux détecteurs correspondant à un même événement 25 sont identifiés par :

- un intervalle de temps séparant les dates des signaux détectés sur deux enregistrements qui, compte tenu des dimensions de l'aéronef et de la position des détecteurs, sont nécessairement compris dans une fenêtre temporelle limitée pour un même événement, et qui permet d'exclure d'un événement les signaux enregistrés à l'extérieur de ladite fenêtre temporelle ;
- le cas échéant, des formes et ou intensités des signaux enregistrés qui correspondent à une signature de décharge électrostatique et qui peut être identifiée sur les différents enregistrements d'un même événement.

Ces différentes méthodes d'identification, ou d'autres méthodes de traitement du signal, peuvent chacune être suffisante pour regrouper les événements, en particulier dans des conditions faiblement perturbées. Elles peuvent également être combinées pour une meilleure corrélation des enregistrements, en particulier dans un environnement fortement perturbé.

Les enregistrements des signaux, reçus par les différents détecteurs et identifiés comme correspondant à un même événement 25, sont alors comparés entre eux pour attribuer à l'événement leurs ayant donné naissance des attributs de mêmes natures que ceux attribués dans la base de données 22 de référence à chacune des origines Op du maillage 12.

Dans une sous-étape 254 de comparaison, suivant dans le procédé la sous étape 252 de regroupement, les attributs identifiés pour l'événement 25 enregistré considéré sont comparés aux attributs de chacune des origines **Op** de la base de données 22 de référence de sorte à identifier un sous-ensemble 23 d'origines dont les attributs sont les plus proches de ceux de l'événement enregistré considéré.

Le nombre d'origines du sous-ensemble n'est pas imposé mais il est avantageusement de l'ordre de trois au moins.

A titre d'illustration d'un exemple de mise en oeuvre de cette étape d'analyse 250 du procédé, il peut être considéré que quatre détecteurs **D1, D2, D3** et **D4** sont utilisés dans le procédé et que le moment, i.e. la date, à laquelle sont reçus les signaux électromagnétiques par chaque détecteur sont pris en compte.

Ainsi pour un même événement 25 identifié lors de la sous-étape 252 de regroupement, il est établi des différences de temps **dt** auxquelles le signal de la perturbation électromagnétique est arrivé sur les différents détecteurs en prenant un détecteur, par exemple **D1,** comme référence.

On peut ainsi déterminer pour l'événement considéré les différences de temps :

- **dt21** pour le détecteur **D2** par rapport au détecteur **D1**
- **dt31** pour le détecteur **D3** par rapport au détecteur **D1**
- **dt41** pour le détecteur **D4** par rapport au détecteur **D1**

Les différences de temps sont naturellement prises en valeurs algébriques et peuvent être positives ou négatives suivant que le signal arrive sur un détecteur avant ou après son arrivée sur le détecteur **D1.**

Le triplet de valeurs **[dt21, dt31, dt41]** peut alors être comparé à chacun des triplets équivalents établis dans cet exemple dans la base de données 22 de référence, c'est-à-dire à tous les triplets **[dt21p, dt31p, dt41p], p** variant de 1 à **M** le nombre d'origines du maillage 12, de sorte à identifier les origines dont les triplets sont les plus proches du triplet de l'événement.

La distance entre deux triplets est par exemple calculée comme l'écart quadratique moyen entre les valeurs de **dt**, soit par rapport à l'origine **Op,** à une constante prés :

$$[(dt21-dt21p)**2 + (dt31-dt31p)**2 +(dt41-dt41p)**2]**-2$$

Ces écarts calculés pour les origines **Op** permettent de déterminer un sous ensemble d'origines pour lesquelles les écarts varient de manière cohérente par rapport à un barycentre des origines vers lequel l'écart tend vers zéro. Il est ainsi possible d'éliminer des origines singulières présentant un écart faible mais non nécessairement cohérent avec les écarts des origines voisines.

Il est bien sûr possible de mettre en oeuvre tout autre type d'algorithme connu pour calculer des distances entre des ensembles de variables.

Dans une troisième sous-étape 256 de cartographie, les coordonnées des origines formant le sous-ensemble identifié à l'étape précédente sont traitées pour définir une zone sur la surface extérieure 11 de l'aéronef correspondant sensiblement à une zone 14 regroupant les emplacements déterminés des origines du sous-ensemble ou de leur interprétation, emplacements conservés dans la base de données 22 pour chaque origine, zone qui est considéré comme la zone dans laquelle est supposé s'être produit l'événement 25.

Cette zone 14 est alors présentée 256 à un opérateur, avantageusement sous forme graphique ou alphanumérique, sur un écran et ou sur un listing.

L'opérateur est alors à même de mener, suivant sa pratique professionnelle, des investigations détaillées, autant que de besoin en mettant en oeuvre des instruments de mesure, sur une zone limitée de l'aéronef.

L'étape d'analyse 250 peut avantageusement être appliquée à chaque événement identifié dans un enregistrement avant de réaliser des investigations sur l'avion.

En effet les conditions atmosphériques associées à l'accumulation de charges électrostatiques, conduisant potentiellement à des décharges électrostatiques, ont une forte probabilité de déclencher une pluralité de décharges au cours d'un vol. Les événements enregistrés peuvent donc permettre de détecter différentes zones soulevant un problème de continuité électrique et ou il peut être constaté plusieurs décharges conduisant à la même zone sur la surface de l'avion confirmant ainsi l'authentification d'un défaut dans ladite zone.

En pratique, suivant la densité du maillage 12 des origines **Op** et la fréquence d'échantillonnage des signaux reçus par les détecteurs **Di,** la résolution théorique du procédé peut être relativement précise et conduire à des zones 14 identifiées relativement petites. Toutefois, de nombreux paramètres non nécessairement pris en compte peuvent conduire à des incertitudes sur les valeurs calculées et sur les valeurs enregistrées, et il n'est pas nécessairement utile de circonscrire des zones 14 de trop petites dimensions qui pourraient conduire l'opérateur à limiter ses investigations et passer à côté de la cause réelle des décharges électrostatiques qu'il recherche.

Une zone 14 de l'ordre d'un mètre carré ressort, sur la structure d'un avion civil de transport, comme un bon compromis entre l'intérêt de limiter la zone d'investigation et celui de ne pas trop restreindre cette zone.

L'invention concerne également un ensemble pour la mise en oeuvre du procédé qui vient d'être décrit.

Comme l'illustre la description du procédé, ce dernier comporte trois étapes principales qui dans leurs mises en oeuvre successives sont réalisées chacune par des moyens adaptés.

L'ensemble comporte donc à cette fin trois systèmes complémentaires mis en oeuvre pour réaliser successivement l'étape préalable 210, l'étape d'enregistrement 230 et l'étape d'analyse 250.

Un premier système, ayant pour finalité la construction de la base de données de référence 22, est mis en oeuvre pour réaliser l'étape préalable 210 de caractérisation.

Le premier système comporte principalement des moyens de calculs numériques, aujourd'hui conventionnels, lesquels sont programmés pour déterminer par calculs, en un point donné d'une structure 11 d'un aéronef connue, les caractéristiques d'un signal électromagnétique, ayant une origine en un autre point de ladite structure.

Pour cela les moyens de calculs comportent une mémoire d'un modèle numérique 21 de la structure 11, au moins pour des parties de la structure susceptibles d'influencer significativement la propagation des signaux électromagnétiques considérés.

Ce modèle numérique 21 comporte également les positions sur ladite structure de détecteurs **Di** d'ondes électromagnétiques.

Dans le premier système, le modèle numérique de la structure en mémoire correspond à celui d'un type aéronef auquel il est souhaité appliquer le procédé.

Les moyens de calculs comportent également une mémoire d'instructions et une unité arithmétique et logique, avantageusement un ou plusieurs processeurs, pour réaliser les calculs et organiser les données.

Il est d'abord procédé à un maillage 12 de la structure de l'aéronef 10.

Si, comme c'est généralement le cas pour les décharges électrostatiques résultant de l'accumulation de charges électriques sous l'effet du frottement aérodynamique, il est considéré des décharges électrostatiques proches d'une surface extérieure de l'aéronef, le maillage 12 est principalement un maillage de ladite surface extérieure.

Le maillage 12 est réalisé avantageusement en faisant appel à un des nombreux logiciels existant de maillage, par exemple le logiciel HyperMesh de la société Altair, paramétré pour répondre aux besoins du procédé, en particulier en termes de résolution.

Le premier système est également configuré avec un logiciel de simulation de la propagation des ondes électromagnétiques pour calculer en un point de la structure 11 les caractéristiques d'une onde résultant d'une onde électromagnétique émise en un autre point de la structure.

Pour cela il est fait appel dans le programme de la mémoire d'instructions à une simulation basée sur les lois de propagation des ondes radioélectriques établies par les équations de Maxwell et appliquées à l'environnement formé par la structure de l'aéronef.

Le programme est exécuté pour chacun des points du maillage 12, considérés comme des sources **Op** de l'onde électromagnétique, afin de déterminer des caractéristiques d'un signal 13 correspondant à l'onde électromagnétique aboutissant sur chacun des détecteurs **Di** suite à l'émission au niveau d'une source **Op** d'une onde électromagnétique de référence, avantageusement dont le spectre est représentatif de celui résultant d'une décharge électrostatique moyenne.

Pour mémoire une décharge électrostatique, dans les conditions considérées, émet une onde dont les fréquences sont principalement comprises entre 10 KHz et 1 GHz.

Pour chaque point du maillage, les caractéristiques calculées pour chacun des détecteurs **Di,** en particulier les durées de propagation de l'onde électromagnétique et les profils d'onde associés, sont mémorisées dans la base de données de référence 22

Le premier système de construction de la base de données de référence 22, non représenté sur les dessins, présente une architecture conventionnelle de centre de calculs de simulation dont l'application est ici spécifique à la création de la base de données de référence 22.

Un second système 50, mis en oeuvre pour l'étape d'enregistrement 230, est embarqué sur l'aéronef 10, comme illustré sur la figure 6a pour lequel des enregistrements 24 sont réalisés au cours de vols dudit aéronef.

Ce second système n'est pas lié fonctionnellement au premier système, mais lui est associé en ce que le modèle numérique 21 de la structure utilisé est celui du type d'aéronef sur lequel ledit second système est embarqué et que les détecteurs sont placés dans le modèle numérique aux emplacements des détecteurs sur ledit aéronef.

Le second système 50 comporte principalement des détecteurs **Di** (i= 1 à N) répartis sur la structure de l'aéronef, des moyens d'enregistrement 51 de signaux reçus par lesdits détecteurs, et des supports de transmission 53 des signaux reçus par chaque détecteur **Di** aux dits moyens d'enregistrement.

Dans l'exemple de réalisation illustré sur la figure 6a et le détail de la figure 6b, les détecteurs ne réalisent pas de traitement des signaux reçus, tout au plus ils réalisent un filtrage pour extraire une composante recherchée des signaux parvenant aux dits détecteurs.

Les signaux reçus sont transmis par les supports de transmission 53, par exemple une liaison par un câble coaxial adapté aux fréquences considérées.

Chaque support de transmission abouti à un échantillonneur 52 qui assure un échantillonnage des signaux reçus par les moyens d'enregistrement 51 de chacun des détecteurs **Di.**

Les moyens d'enregistrement comportent également une base de temps 54 qui communique un temps absolu à des moyens de synchronisation 57 réalisant une synchronisation des échantillonneurs et en attribuant une date à laquelle le signal échantillonné est parvenu sur le détecteur correspondant.

Les moyens d'enregistrement comportent également un enregistreur 55 dans lequel les signaux reçus par chaque détecteur puis échantillonnés sont enregistrés avec les données de date établies par la base de temps.

Pour établir la date à laquelle un signal est parvenu à un détecteur **Di,** les moyens de synchronisation 57 corrigent, pour chaque détecteur, la date à laquelle le signal est arrivé aux dits moyens d'enregistrement d'un temps de propagation du signal entre ledit détecteur et les dits moyens d'enregistrement. La valeur de la correction apportée à une date dépend de la durée que met le signal à parcourir la chaîne de transmission du signal et peut être établie par tout moyen tel qu'un calcul ou une mesure initiale.

Il doit être noté que la correction peut être réalisée par des moyens analogiques ou de préférence dans une chaîne de traitement numérique directement par calcul.

Il doit être noté que la précision de la date associée à un signal dans les moyens d'enregistrement 51 dépend de la précision avec laquelle le signal est vu par lesdits moyens d'enregistrement. Cette précision dépend en pratique d'une fréquence d'échantillonnage du signal qui est reçu par les moyens d'enregistrement.

Plus la fréquence d'échantillonnage est élevée, plus la précision de la date sera élevée, au moins en théorie.

En pratique, la fréquence d'échantillonnage sera choisie de manière cohérente avec la précision recherchée pour éviter un sur-échantillonnage qui aurait pour effet d'augmenter la taille des enregistrements sans bénéfice pratique sur la précision.

Dans le cas du présent dispositif, un échantillonnage avec une période de 0,5 à 3 nanosecondes est adapté. Par exemple une période d'échantillonnage de 3 nanosecondes (330 MHz) permet d'identifier de manière relativement fiable un début d'impulsion électromagnétique reçue compte tenu de la période d'échantillonnage et d'atteindre une précision de l'ordre du mètre sur la distance estimée entre l'emplacement d'une décharge électrostatique et un détecteur.

Dans un exemple préféré de réalisation, les données sont stockées dans une mémoire non volatile des moyens d'enregistrement 55.

Le dispositif d'enregistrement 51 comporte également des moyens pour transmettre les données enregistrées en vue de leur traitement.

Par exemple le dispositif d'enregistrement 51 peut comporter un support de mémoire amovible, ou, comme dans l'exemple illustré sur la figure 6b, comporter des moyens de liaison numérique 58 aptes à transmettre les données enregistrées par exemple par une prise pour le téléchargement du contenu de l'enregistrement, et ou par des moyens d'émission à courte distance radio ou optique pour transmettre le contenu de l'enregistrement, et ou par un bus numérique de connexion à des systèmes de communication de l'aéronef tel qu'un système « datalink » ou un système « gatelink ». Dans les différentes solutions de transfert par téléchargement du contenu de la mémoire, les liaisons assurées sont de préférence bidirectionnelles pour commander le téléchargement à distance et pour réinitialiser les moyens d'enregistrement.

Ces solutions de transfert ne sont que des exemples, tout moyen de transfert adapté à l'environnement et au flux de données à transmettre pouvant être utilisé.

Le troisième système 60 d'analyse, illustré schématiquement sur la figure 7, consiste principalement en des moyens de calculs numériques 61 configurés pour réaliser l'étape d'analyse 250 des données enregistrées par le deuxième système 50 lors du vol.

Pour cela le troisième système 60 comporte une mémoire locale dans laquelle sont chargés les enregistrements 24, comporte des moyens d'accès à la base de données 22, ou comporte localement une copie de cette base de données, créée préalablement par le premier système, et comporte des moyens d'accès au modèle numérique 21 de la structure de l'aéronef, ou comporte localement une copie de ce modèle numérique, au moins pour ce qui concerne la géométrie de la surface extérieure de l'aéronef.

Les moyens de calculs du troisième système 60, d'architecture conventionnelle, sont configurés par la mise en oeuvre de logiciels pour :

- 1- comparer les enregistrements des signaux reçus sur les différents détecteurs **Di** de sorte à identifier les séquences correspondant, au moins avec une probabilité supérieure à une valeur seuil choisie, à un même événement 25 reçu sur chacun des détecteurs ou sur un sous-ensemble prédéterminé de détecteurs. Un tel sous ensemble est alors pris en compte pour la recherche de l'emplacement d'un événement dans une partie de la structure de l'aéronef. Une telle identification est obtenue par une corrélation des formes de signaux enregistrés provenant des différents détecteurs et ou qui sont datés dans une fenêtre de temps compatible avec des distances séparant les différents détecteurs.

  Il doit être noté que la forme d'un signal émis par une décharge électrostatique peut être très différente d'une décharge à une autre, du fait que la structure ainsi que des conditions locales influent sur la forme du signal électromagnétique émis, en particulier une différence de potentiel au moment de la décharge. Statistiquement, le signal de chaque décharge électrostatique est spécifique et une signature propre à la décharge considérée est susceptible de se retrouver dans les signaux reçus sur chaque détecteur.

- 2- établir pour chaque événement identifié un ensemble de caractéristiques équivalentes aux caractéristiques associées dans la base de données 22 de référence à chacune des origines **Op,** en particulier des écarts de temps d'arrivée sur les différents détecteurs **Di** des signaux émis par un même événement.

- 3- comparer ledit ensemble de caractéristiques de l'événement à chacun des ensembles de caractéristiques correspondant des origines Op de la base de données 22 de référence, et calculer pour chacune des dites origines Op une distance entre l'ensemble de caractéristiques de l'événement et l'ensemble de caractéristiques de l'origine Op considérée. Le terme distance n'est pas à prendre ici comme une distance géométrique mais comme la distance séparant deux points d'un espace de dimension k, où k est une dimension d'un vecteur correspondant à l'ensemble de caractéristiques attribué à un événement.

- 4- identifier un sous-ensemble d'origines 23 dont les distances calculées sont minimales.

- 5- définir, par la localisation connue dans la base de données de référence 22 comportant la position de chacune des origines Op, la position sur une surface de la structure de la zone 14 de l'emplacement correspondant au sous-ensemble d'origines 23 et dans lequel est probablement localisé la décharge électrostatique correspondant à l'événement examiné, et présenter ledit emplacement probable sur un écran 62 ou un listing ou tout autre moyen approprié des moyens de calculs 61, avantageusement de manière graphique, combiné ou non à d'autre forme de présentation, sur une représentation de la structure de l'aéronef.

Il est compris de la description du procédé et de l'exemple de dispositif de l'invention pour la mise en oeuvre du procédé que ledit procédé et ledit dispositif sont susceptibles de variantes sans se démarquer de la présente invention.

En particulier, l'homme du métier pourra choisir parmi différents modèles et équations associées qui peuvent être considérées, et différents algorithmes de résolution qui peuvent être mis en oeuvre, pour décrire les phénomènes physiques mis en jeu dans l'invention.

En fonction d'une expérience acquise et du type d'aéronef considéré, l'homme du métier adaptera avantageusement le nombre de points du maillage de la structure et la densité en résultant à la surface de la structure de l'aéronef, en particulier pour répondre à une précision de la localisation des événements.

Il pourra également adapter la période d'échantillonnage des signaux.

La répartition physique des fonctions peut également être différente de la répartition présentée dans l'exemple de réalisation du schéma de la figure 6b.

Par exemple l'échantillonneur 52 peut être combiné au détecteur auquel il est associé et transmettre les signaux numérisés aux moyens d'enregistrements 51.

Les corrections de dates pour prendre en compte les longueurs des supports de transmission 53 peuvent également être effectuées de différentes manières, suivant des méthodes connues dans le domaine de la synchronisation des signaux.

Le sous-ensemble d'origine 23 comporte par exemple trois points du maillage.

Il peut toutefois ne comporter qu'un seul point dans le cas d'un point unique identifié avec un écart inférieur à un seuil donné entre les différences de temps établies par la mesure sur l'événement considéré et les différences de temps établies par simulation pour chacun ledit point du maillage. Dans ce cas le point retenu peut être associé à un périmètre d'incertitude choisi pour délimiter une zone d'investigation.

Le sous-ensemble peut également comporter un nombre plus important de points délimitant une zone sur la surface de la structure de l'aéronef, le cas échéant en déterminant dans ladite zone des zones plus ou moins concentriques correspondant à des probabilités différentes de localisation de la décharge électrostatique.

Dans une forme de mise en oeuvre du procédé, l'étape préalable 210 de caractérisation est évitée en utilisant les mêmes algorithmes de calcul direct de la propagation des signaux radioélectrique émis suivant une méthode de proche en proche dans laquelle, à partir d'une origine possible de la décharge électrostatique, par exemple établie par les différences de temps d'arrivée des signaux sur les capteur ou une méthode de trilatération, et des différences entre les signaux enregistrés et ceux calculés de la source possible, il est identifié une nouvelle origine plus proche de la décharge électrostatique, le processus étant répété pour converger vers l'emplacement le plus probable de la décharge électrostatique.

Dans une autre forme de mise en oeuvre, indépendamment ou en complément des méthodes par calculs directs, il est appliqué aux données des enregistrements des méthodes de calculs inverses de la propagation des ondes électromagnétiques pour remonter des détecteurs à la source des signaux observés.

Un tel traitement met en oeuvre des algorithmes classiquement mis en oeuvre dans le domaine des radars, dans le domaine des réseaux de communication ou dans le domaine de la goniométrie, par exemple les algorithmes de Fourier ou Prony ou Capton appliqués aux méthodes des sous espaces (e.g. MUSIC ou ESPRIT) ou au méthodes dites LES (Least Square Error).

Il est alors utilisé un modèle de la structure de l'aéronef, mais sans nécessité de réaliser la première étape du procédé.

Comme il est compris de la description du procédé, il n'y a pas d'exigence d'un traitement en temps réel des enregistrements.

En effet si les enregistrements doivent nécessairement être réalisés pendant le vol, ce qui implique que le deuxième système 50 soit embarqué sur l'aéronef, l'exploitation des dits enregistrements n'est utile que pour réaliser sur l'aéronef les investigations et opérations correctives éventuelles qui ne peuvent être conduites que sur l'aéronef immobilisé au sol.

De ce fait, bien que le troisième système 60 d'analyse puisse être associé sur l'aéronef avec le deuxième système 50 d'enregistrement, et dans ce cas délivrer directement la localisation des zones de décharges électrostatiques sur la structure, ledit troisième système est avantageusement installé au sol, par exemple dans un centre de maintenance, pour traiter les enregistrements avant leur exploitation.

Cette dernière option d'une part évite d'embarquer sur l'aéronef un dispositif qui est inutile pour l'équipage de vol et d'autre part permet à l'opérateur de maintenance de suivre le déroulement de l'analyse et le cas échéant d'intervenir dans ce déroulement pour lever des ambiguïtés et ou interpréter les résultats de l'analyse de manière interactive.

A ce titre il peut être remarqué, qu'il n'est pas nécessairement recherché une identification de tous les événements s'étant produit au cours d'un vol. Il est probable qu'une zone présentant un défaut de continuité électrique de la structure de l'aéronef sera à l'origine de plusieurs décharges électrostatiques. Avantageusement l'opérateur de maintenance saura, par expérience en visualisant des enregistrements, sélectionner ceux, les plus caractéristiques et les moins bruités, qui seront susceptibles de fournir une localisation fiable.

Le troisième système 60 d'analyse utilise des données fonction de la structure de l'aéronef pour lequel la recherche d'emplacement de décharges électrostatiques doit être menée.

Dans une forme de réalisation, ledit troisième système comporte une base d'aéronefs dans laquelle sont stockées les bases de données de référence 22 correspondant à différents modèles d'aéronefs. Dans ce cas, la mise en oeuvre de l'étape de traitement des données implique la sélection préalable du modèle d'aéronef sur lequel ont été réalisés les enregistrements.

Dans une forme de réalisation du deuxième système 50 d'enregistrement, embarqué sur l'aéronef, les détecteurs peuvent être des détecteurs spécialisés placés sur la structure en des emplacements choisis.

Dans ce cas, le nombre et les positions des détecteurs peuvent être choisis pour optimiser les conditions d'enregistrement et de détermination des zones de décharges électrostatiques.

Cette solution présente cependant l'inconvénient d'impacter la définition de la structure en nécessitant des trous et le montage de renforts et platines pour placer les détecteurs.

Dans une autre forme de réalisation du deuxième système 50 d'enregistrement, il est tiré parti des antennes existantes sur l'aéronef 10.

En effet, les aéronefs modernes utilisent des moyens radio, radio communications ou radio navigations, qui nécessitent d'agencer des antennes 16 sur la structure de l'aéronef. Diverses de ces antennes, en raison de leurs caractéristiques radioélectriques, sont adaptées à la réception des signaux émis par les décharges électrostatiques.

Il est dans cette forme de réalisation placé entre une antenne 16 et les moyens d'enregistrement 51 un coupleur 56, comme illustré sur les détecteurs **D1** et **D2** de la figure 6b, de sorte qu'une partie du signal reçu puisse être transmise aux moyens d'enregistrement 51, le reste du signal étant transmis à l'équipement auquel il est destiné, par exemple une radio VHF.

De la sorte, il n'est pas nécessaire, d'installer sur la structure des détecteurs spécifiques, ou pour le moins de limiter le nombre de ces détecteurs spécifiques.

Un coupleur d'antenne 56 est par exemple installé à proximité de l'antenne 16. Un coupleur d'antenne 56 peut également être installé à proximité de l'équipement utilisant l'antenne, solution avantageuse lorsque ledit équipement et les moyens d'enregistrement 51 sont installés dans l'aéronef à proximité l'un de l'autre, par exemple dans une baie avionique.

A ce titre il peut être remarqué que si les antennes radio 16 de l'aéronef 10 sont toutes agencées dans un plan de symétrie dudit aéronef, agencement qui se constate sur de nombreux avions, l'exploitation des signaux enregistrés pour ces seules antennes mises en oeuvre comme détecteurs **Di** conduira à définir deux zones probables pour une décharge électrostatique, placées symétriquement sur l'aéronef.

Dans ce cas il peut être avantageux d'installer en plus des antennes au moins un détecteur afin d'identifier de quel côté du plan de symétrie de l'aéronef s'est produite la décharge électrostatique.

Pour un fonctionnement satisfaisant de l'ensemble, il est avantageux de mettre en oeuvre au moins trois détecteurs dans le second système 50, une valeur supérieure du nombre **N** de détecteurs étant avantageusement considérée en fonction de la précision de localisation des décharges électrostatiques souhaitée et des caractéristiques de l'aéronef.

Ainsi l'invention permet d'identifier, sinon un emplacement exact sur une structure d'aéronef où s'est effectivement produit en vol une décharge électrostatique, au moins une zone réduite de la surface extérieure de l'aéronef dans laquelle s'est produite la décharge électrostatique.

Il est alors donné à un opérateur de maintenance la possibilité d'intervenir dans une zone réduite, par exemple de l'ordre de 1 m2 alors que la surface extérieure d'un aéronef est généralement de plusieurs centaines de mètres carrés.

Cette surface réduite permet une intervention beaucoup plus rapide dans la recherche des causes exactes de la ou des décharges électrostatiques et en conséquence d'en déduire les mesures correctives qui peuvent être appliquées.

Il en résulte une immobilisation de l'aéronef beaucoup plus courte et une efficacité des mesures prises améliorée du fait que les causes exactes sont plus rapidement et mieux identifiées.

**Revendications**

1. Procédé (200) de localisation d'une décharge électrostatique apparue sur une surface extérieure d'un aéronef (10) en vol, le procédé comportant :

   ○ une étape d'enregistrement (230) pendant le vol de l'aéronef de signaux (13) électromagnétiques, conséquences de décharges électrostatiques, reçus par une pluralité de détecteurs **Di** agencés en différents emplacements sur la surface extérieure dudit aéronef ;
   ○ une étape d'analyse (250) des signaux (13) enregistrés pendant le vol, dans laquelle étape d'analyse des caractéristiques de chacun des signaux, reçus par les différents détecteurs et correspondant à ladite décharge électrostatique à localiser, sont traités pour identifier au moins une zone (14) d'une surface extérieure de l'aéronef (10), déterminant une partie de structure dans laquelle s'est probablement produite ladite décharge électrostatique ;

et dans laquelle étape d'analyse (250) des algorithmes de propagation inverse des ondes électromagnétiques sont appliqués aux données enregistrées des signaux reçus par les détecteurs pour déterminer la zone (14) sur la surface extérieure de l'aéronef où s'est probablement produite la décharge électrostatique à l'origine desdits signaux électromagnétiques, ou des données desdits signaux enregistrées sont comparées à des données, simulées par des algorithmes de propagation directe des ondes électromagnétiques appliqués à des sources d'émission électromagnétique d'emplacements choisis sur la structure de l'aéronef, pour déterminer par comparaison la zone (14) sur la surface extérieure de l'aéronef où s'est probablement produite la décharge électrostatique à l'origine desdits signaux électromagnétiques.

2. Procédé suivant la revendication 1 dans lequel l'étape d'enregistrement (230) comporte une étape d'échantillonnage (234) des signaux reçus par chaque détecteur $D_i$ et de datation des dits signaux par rapport à une base de temps commune à l'ensemble des détecteurs.

3. Procédé suivant la revendication 2 dans lequel les signaux échantillonnés et datés sont enregistrés (236) dans une mémoire permanente d'un système d'enregistrement (51) embarqué de l'aéronef.

4. Procédé suivant l'une des revendications 1 à 3 dans lequel, lorsqu'il est enregistré des signaux conséquences d'une pluralité de décharges électrostatiques, l'étape d'analyse (250) comporte une sous-étape de regroupement (252) des enregistrements des détecteurs $D_i$ par événements (25), un événement correspondant à une décharge électrostatique pendant le vol de l'aéronef.

5. Procédé suivant la revendication 4 dans lequel des enregistrements de signaux reçus par les détecteurs $D_i$ sont identifiés comme pouvant appartenir à un même événement lorsque les dates correspondant aux dits enregistrements sont comprises dans une fenêtre temporelle prédéfinie, compte tenue des dimensions de l'aéronef.

6. Procédé suivant la revendication 4 ou la revendication 5 dans lequel une signature est établie par des formes et ou intensités d'un signal enregistré reçus par un détecteur $D_i$, les enregistrements de signaux de différents détecteurs correspondant à une même signature étant considérés comme correspondant à un même événement.

7. Procédé suivant l'une des revendications précédentes dans lequel des caractéristiques des enregistrements des détecteurs $D_i$ correspondant à la décharge électrostatique à localiser sont comparées aux effets, mesurés ou calculés, d'une onde électromagnétique émise par chacun des points d'un maillage (12) de la surface extérieure de la structure de l'aéronef et dans lequel la zone (14) est définie par un sous-ensemble (23) des points du maillage dont des caractéristiques sont les moins distantes des caractéristiques du signal mesuré.

8. Procédé suivant la revendication 7 comportant une étape préalable (210) de création d'une base de données de référence (22), dans laquelle base de données de référence les caractéristiques des signaux reçus par chacun des détecteurs $D_i$ sont définis pour chacun des points du maillage (12) considéré comme source d'émission d'une onde électromagnétique.

9. Procédé suivant l'une des revendications précédentes comportant une étape (256) d'identification sous forme graphique et ou numérique de la zone (14) sur la surface extérieure de l'aéronef (10).

10. Ensemble pour localiser sur une structure (11) d'un aéronef (10) au moins une décharge électrostatique apparue en vol, ledit ensemble comportant :

- au moins un système d'enregistrement (50) embarqué sur l'aéronef, ledit système d'enregistrement comportant :

- une pluralité de détecteurs $D_i$ destinés à être agencés en des emplacements différents sur une surface extérieure de la structure de l'aéronef ;
- des moyens d'échantillonnage (52) de signaux (13) électromagnétiques reçus par chaque détecteur de la pluralité de détecteurs ;

- des moyens de datation (54) desdits signaux électromagnétiques reçus, et ;
- des moyens de mémorisation permanente des signaux échantillonnés et datés reçus par chacun des détecteurs **Di** ;

- au moins un système d'analyse (60) comportant des moyens de traitement (61) des signaux, enregistrés par le système d'enregistrement (50), dans lesquels moyens de traitement un ou des modèles numériques de propagation des ondes électromagnétiques sont mis en oeuvre pour déterminer une zone (14) de la surface extérieure de la structure (11) de l'aéronef dans laquelle s'est probablement produite une décharge électrostatique identifiée comme à l'origine de signaux enregistrés, lesdits moyens de traitement des signaux (61) du système d'analyse (60) comportant un simulateur incorporant des algorithmes de propagation inverse des ondes électromagnétiques et appliquant lesdits algorithmes de propagation inverse aux signaux (13), reçus par les détecteurs **Di,** pour localiser une zone (14), sur la surface extérieure de la structure (11) de l'aéronef, dont lesdits signaux émis par une décharge électrostatique sont issus, ou comportant un simulateur incorporant des algorithmes de propagation directe des ondes électromagnétiques et appliquant lesdits algorithmes pour déterminer, par comparaison entre les données enregistrées, correspondant aux signaux reçus par les détecteurs **Di,** et des données similaires simulées, une zone (14), sur la surface extérieure de la structure (11) de l'aéronef, dont les signaux émis par une décharge électrostatique sont issus.

11. Ensemble suivant la revendication 10 dans lequel le système d'enregistrement (50) comporte des moyens, physiques ou logiques, de synchronisation (57) des dates attribuées aux signaux reçus par les détecteurs, les dits moyens de synchronisation compensant des différences de durée de transmission des signaux entre les détecteurs et des moyens d'enregistrement (51).

12. Ensemble suivant la revendication 10 ou la revendication 11 dans lequel au moins un détecteur met en oeuvre une antenne (16) hertzienne de l'aéronef à laquelle est adjoint un coupleur d'antenne (56) raccordé d'une part à un câble d'antenne destiné à un équipement de l'aéronef, pour lequel est installée ladite antenne, et d'autre part à un support de transmission (53) raccordé au moyen d'enregistrement (51).

13. Ensemble suivant l'une des revendications 10, 11 ou 12 dans lequel le système d'enregistrement (50) comporte des moyens de liaison numérique (58) de transfert de données avec une installation sol pour transférer les données enregistrées par ledit système d'enregistrement vers le système d'analyse (60).

14. Ensemble suivant l'une des revendications 10 à 13 dans lequel les moyens de traitement (61) du système d'analyse (60) déterminent que des enregistrements de signaux reçus par les détecteurs Di peuvent appartenir à un même événement lorsque les dates correspondant aux dits enregistrements sont comprises dans une fenêtre temporelle prédéfinie, compte tenue des dimensions de l'aéronef.

15. Ensemble suivant l'une des revendications 10 à 14 dans lequel les moyens de traitement (61) du système d'analyse (60) établissent une signature par des formes et ou intensités d'un signal enregistré reçus par un détecteur Di, les enregistrements de signaux de différents détecteurs correspondant à une même signature étant considérés comme correspondant à un même événement.

16. Ensemble suivant l'une des revendications 10 à 15 comportant un premier système de construction d'une base de données de référence (22), ledit premier système comportant un modèle numérique (21) de la structure de l'aéronef (10), sur une surface extérieure duquel aéronef est défini un maillage (12) déterminant des origines arbitraires d'ondes électromagnétiques, ledit premier système comportant un simulateur incorporant les algorithmes de propagation directe des ondes électromagnétiques, la base de données de référence (22) comportant pour chaque origine Op définie par le maillage (12) au moins une information de position de ladite origine sur la surface extérieure de la structure (11) de l'aéronef et des caractéristiques calculées de temps et ou de forme de chacun des signaux reçus par chacun des détecteurs **Di** suite à une émission simulée d'une onde électromagnétique à l'emplacement de ladite origine.

17. Ensemble conforme à l'une des revendications 10 à 16 comportant en outre un aéronef dans lequel est installé le système d'enregistrement (50) des signaux (13) électromagnétiques émis par des décharges électrostatiques sur ledit avion.

18. Ensemble suivant la revendication 16 ou la revendication 17 dans lequel des antennes (16) de réception de radiocommunication et ou de radionavigation de l'aéronef sont également utilisées comme détecteurs Di du système d'enregistrement (50).

**Patentansprüche**

1. Verfahren (200) zur Ortung einer elektrostatischen Entladung, die auf einer Außenoberfläche eines Flugzeugs (10) im Flug aufgetreten ist, wobei das Verfahren umfasst:

   o einen Schritt des Aufzeichnens (230) von elektromagnetischen Signalen (13), die die Folge von elektrostatischen Entladungen sind, die von einer Vielzahl von Detektoren **Di** empfangen werden, die an verschiedenen Stellen auf der Außenoberfläche des Flugzeugs angeordnet sind, während des Fluges des Flugzeugs;
   o einen Schritt des Auswertens (250) der während des Fluges aufgezeichneten Signale (13), wobei bei dem Auswertungsschritt Merkmale jedes der Signale, die von den verschiedenen Detektoren empfangen werden und der zu ortenden elektrostatischen Entladung entsprechen, verarbeitet werden, um mindestens einen Bereich (14) einer Außenoberfläche des Flugzeugs (10) zu identifizieren, der einen Strukturteil bestimmt, in dem die elektrostatische Entladung wahrscheinlich eingetreten ist;

   und wobei im Auswertungsschritt (250) Algorithmen für die inverse Ausbreitung der elektromagnetischen Wellen auf die aufgezeichneten Daten der von den Detektoren empfangenen Signale angewandt werden, um den Bereich (14) auf der Außenoberfläche des Flugzeugs zu bestimmen, in dem die elektrostatische Entladung, die der Ausgangspunkt der elektromagnetischen Signale ist, wahrscheinlich eingetreten ist, oder Daten der aufgezeichneten Signale mit Daten verglichen werden, die von Algorithmen für die direkte Ausbreitung der elektromagnetischen Wellen simuliert werden, die auf Quellen für die elektromagnetische Aussendung an ausgewählten Stellen auf der Struktur des Flugzeugs angewandt werden, um durch Vergleichen den Bereich (14) auf der Außenoberfläche des Flugzeugs zu bestimmen, in dem die elektrostatische Entladung, die der Ausgangspunkt der elektromagnetischen Signale ist, wahrscheinlich eingetreten ist.

2. Verfahren nach Anspruch 1, wobei der Aufzeichnungsschritt (230) einen Schritt des Abtastens (234) der Signale, die von jedem Detektor **Di** empfangen werden, und des Datierens der Signale in Bezug auf eine allen Detektoren gemeine Zeitbasis umfasst.

3. Verfahren nach Anspruch 2, wobei die abgetasteten und datierten Signale in einem Permanentspeicher eines Aufzeichnungssystems (51) an Bord des Flugzeugs aufgezeichnet werden (236).

4. Verfahren nach einem der Ansprüche 1 bis 3, wobei, wenn Signale aufgezeichnet werden, die die Folge einer Vielzahl von elektrostatischen Entladungen sind, der Auswertungsschritt (250) einen Teilschritt des Zusammenfassens (252) der Aufzeichnungen der Detektoren Di nach Ereignissen (25) umfasst, wobei ein Ereignis einer elektrostatischen Entladung während des Fluges des Flugzeugs entspricht.

5. Verfahren nach Anspruch 4, wobei Aufzeichnungen von Signalen, die von den Detektoren Di empfangen werden, als möglicherweise demselben Ereignis angehörend identifiziert werden, wenn die den Aufzeichnungen entsprechenden Daten in einem unter Berücksichtigung der Abmessungen des Flugzeugs vorgegebenen Zeitfenster enthalten sind.

6. Verfahren nach Anspruch 4 oder Anspruch 5, wobei eine Signatur durch die Formen und oder Intensitäten eines aufgezeichneten Signals, das von einem Detektor Di empfangen wird, erstellt wird, wobei die Aufzeichnungen von Signalen verschiedener Detektoren, die derselben Signatur entsprechen, als demselben Ereignis entsprechend betrachtet werden.

7. Verfahren nach einem der vorhergehenden Ansprüche, wobei Merkmale der Aufzeichnungen der Detektoren **Di,** die der zu ortenden elektrostatischen Entladung entsprechen, mit den gemessenen oder berechneten Wirkungen einer elektromagnetischen Welle verglichen werden, die von jedem der Punkte eines Gitternetzes (12) der Außenoberfläche der Struktur des Flugzeugs ausgesendet wird, und wobei der Bereich (14) durch eine Untergruppe (23) der Punkte des Gitternetzes definiert wird, deren Merkmale am wenigsten weit von den Merkmalen des gemessenen Signals entfernt sind.

8. Verfahren nach Anspruch 7, umfassend einen vorherigen Schritt (210) des Anlegens einer Referenzdatenbank (22), wobei in der Referenzdatenbank die Merkmale der von jedem der Detektoren Di empfangenen Signale für jeden der Punkte des Gitternetzes (12), der als Quelle für die Aussendung einer elektromagnetischen Welle betrachtet wird, definiert werden.

9. Verfahren nach einem der vorhergehenden Ansprüche, umfassend einen Schritt (256) der grafischen oder digitalen Identifizierung des Bereichs (14) auf der Außenoberfläche des Flugzeugs (10).

10. Anordnung zur Ortung mindestens einer während des Fluges aufgetretenen elektrostatischen Entladung auf einer Struktur (11) eines Flugzeugs (10), wobei die Anordnung umfasst:

   - mindestens ein Aufzeichnungssystem (50) an Bord des Flugzeugs, wobei das Aufzeichnungssystem umfasst:

      - eine Vielzahl von Detektoren **Di,** die dazu bestimmt sind, an verschiedenen Stellen auf einer Außenoberfläche der Struktur des Flugzeugs angeordnet zu werden;
      - Mittel zum Abtasten (52) von elektromagnetischen Signalen (13), die von jedem Detektor der Vielzahl von Detektoren empfangen werden;
      - Mittel zum Datieren (54) der empfangenen elektromagnetischen Signale und
      - Mittel zum permanenten Speichern der abgetasteten und datierten Signale, die von jedem der Detektoren **Di** empfangen werden;

   - mindestens ein Auswertungssystem (60), das Mittel zum Verarbeiten (61) der vom Aufzeichnungssystem (50) aufgezeichneten Signale umfasst, wobei in den Verarbeitungsmitteln ein oder mehrere numerische Modelle für die Ausbreitung der elektromagnetischen Wellen eingesetzt werden, um einen Bereich (14) der Außenoberfläche der Struktur (11) des Flugzeugs zu bestimmen, in dem wahrscheinlich eine elektrostatische Entladung aufgetreten ist, die als Ausgangspunkt für die aufgezeichneten Signale identifiziert wird, wobei die Signalverarbeitungsmittel (61) des Auswertungssystems (60) einen Simulator umfassen, der Algorithmen für die inverse Ausbreitung der elektromagnetischen Wellen beinhaltet und diese Algorithmen für die inverse Ausbreitung auf die Signale (13) anwendet, die von den Detektoren **Di** empfangen werden, um einen Bereich (14) auf der Außenoberfläche der Struktur (11) des Flugzeugs zu orten, aus dem die von einer elektrostatischen Entladung ausgesendeten Signale stammen, oder einen Simulator umfassen, der Algorithmen für die direkte Ausbreitung der elektromagnetischen Wellen beinhaltet und diese Algorithmen anwendet, um durch Vergleich zwischen den aufgezeichneten Daten, die den von den Detektoren **Di** empfangenen Signalen entsprechen, und ähnlichen simulierten Signalen einen Bereich (14) auf der Außenoberfläche der Struktur (11) des Flugzeugs zu bestimmen, aus dem die von einer elektrostatischen Entladung ausgesendeten Signale stammen.

11. Anordnung nach Anspruch 10, wobei das Aufzeichnungssystem (50) physische oder logische Mittel zum Synchronisieren (57) der Daten, die den von den Detektoren empfangenen Signalen zugewiesen werden, umfasst, wobei die Synchronisationsmittel Laufzeitunterschiede der Signale zwischen den Detektoren und den Aufzeichnungsmitteln (51) ausgleichen.

12. Anordnung nach Anspruch 10 oder Anspruch 11, wobei mindestens ein Detektor eine Funkantenne (16) des Flugzeugs einsetzt, der eine Antennenweiche (56) hinzugefügt wird, die zum einen an ein Antennenkabel angeschlossen ist, das für ein Gerät des Flugzeugs bestimmt ist, für das die Antenne installiert ist, und zum anderen an ein Übertragungsmedium (53), das an das Aufzeichnungsmittel (51) angeschlossen ist.

13. Anordnung nach einem der Ansprüche 10, 11 oder 12, wobei das Aufzeichnungssystem (50) digitale Verbindungsmittel (58) zur Datenübertragung mit einer Bodenanlage umfasst, um die von dem Aufzeichnungssystem aufgezeichneten Daten zum Auswertungssystem (60) zu übertragen.

14. Anordnung nach einem der Ansprüche 10 bis 13, wobei die Verarbeitungsmittel (61) des Auswertungssystems (60) bestimmen, dass Aufzeichnungen von Signalen, die von den Detektoren Di empfangen werden, zu demselben Ereignis gehören können, wenn die Daten, die diesen Aufzeichnungen entsprechen, in einem unter Berücksichtigung der Abmessungen des Flugzeugs vorgegebenen Zeitfenster enthalten sind.

15. Anordnung nach einem der Ansprüche 10 bis 14, wobei die Verarbeitungsmittel (61) des Auswertungssystems (60) durch Formen und oder Intensitäten eines aufgezeichneten Signals, das von einem Detektor Di empfangen wird, eine Signatur erstellen, wobei die Aufzeichnungen von Signalen verschiedener Detektoren, die derselben Signatur entsprechen, als demselben Ereignis entsprechend betrachtet werden.

**16.** Anordnung nach einem der Ansprüche 10 bis 15, umfassend ein erstes System zum Aufbauen einer Referenzdatenbank (22), wobei das erste System ein digitales Modell (21) der Struktur des Flugzeugs (10) umfasst, wobei auf einer Außenoberfläche des Flugzeugs ein Gitternetz (12) definiert ist, das willkürliche Ausgangspunkte elektromagnetischer Wellen bestimmt, wobei das erste System einen Simulator umfasst, der Algorithmen für die direkte Ausbreitung der elektromagnetischen Wellen beinhaltet, wobei die Referenzdatenbank (22) für jeden Ausgangspunkt **Op,** der durch das Gitternetz (12) definiert wird, mindestens eine Information zur Lage dieses Ausgangspunktes auf der Außenoberfläche der Struktur (11) des Flugzeugs und berechnete Zeit- oder Formmerkmale für jedes der Signale, die von jedem der Detektoren **Di** nach einer simulierten Aussendung einer elektromagnetischen Welle an der Stelle des Ausgangspunkts empfangen werden, umfasst.

**17.** Anordnung nach einem der Ansprüche 10 bis 16, ferner umfassend ein Flugzeug, in dem das Aufzeichnungssystem (50) zur Aufzeichnung der elektromagnetischen Signale (13), die durch die elektrostatischen Entladungen auf diesem Flugzeug ausgesendet werden, installiert ist.

**18.** Anordnung nach Anspruch 16 oder Anspruch 17, wobei Funkkommunikations- oder Funknavigationsempfangsantennen (16) des Flugzeugs ebenfalls als Detektoren Di des Aufzeichnungssystems (50) verwendet werden.

**Claims**

**1.** Method (200) of locating an electrostatic discharge that has occurred on an exterior surface of an aircraft (10) in flight, the method including:

> ◦ a step (230) during the flight of the aircraft of recording electromagnetic signals (13) stemming from electrostatic discharges and received by a plurality of detectors **Di** arranged at various locations on the exterior surface of said aircraft;
> ◦ a step (250) of analyzing the signals (13) recorded during the flight, in which analysis step characteristics of each of the signals received by the various detectors and corresponding to said electrostatic discharge to be located are processed to identify at least one zone (14) of an exterior surface of the aircraft (10) determining a structure part in which the electrostatic discharge probably occurred;

and in which analysis step (250) inverse electromagnetic wave propagation algorithms are applied to the recorded data of the signals received by the detectors in order to determine the zone (14) on the exterior surface of the aircraft where the electrostatic discharge from which said electromagnetic signals stem probably occurred, or recorded data of said signals are compared with data simulated by direct electromagnetic wave propagation algorithms applied to electromagnetic emission sources at chosen locations on the structure of the aircraft in order to determine by a process of comparison the zone (14) on the exterior surface of the aircraft where the electrostatic discharge from which said electromagnetic signals stem probably occurred.

**2.** Method according to Claim 1 in which the recording step (230) includes a step (234) of sampling the signals received by each detector **Di** and time-stamping said signals relative to a timebase common to all of the detectors.

**3.** Method according to Claim 2 in which the sampled and time-stamped signals are recorded (236) in a permanent memory of a recording system (51) onboard the aircraft.

**4.** Method according to any one of Claims 1 to 3 in which, when signals stemming from a plurality of electrostatic discharges are recorded, the analysis step (250) includes a substep (252) of grouping the recordings from the detectors Di event (25) by event, an event corresponding to an electrostatic discharge during the flight of the aircraft.

**5.** Method according to Claim 4 in which recordings of signals received by the detectors Di are identified as being able to belong to one and the same event when the dates corresponding to said recordings are contained within a predefined time window, taking into account the dimensions of the aircraft.

**6.** Method according to Claim 4 or Claim 5 in which a signature is established through forms or intensities of a recorded signal that are received by a detector Di, the recordings of signals from various detectors corresponding to one and the same signature being considered to correspond to one and the same event.

**7.** Method according to any one of the preceding claims in which characteristics of the recordings from the detectors **Di** corresponding to the electrostatic discharge to be located are compared to the measured or calculated effects of an electromagnetic wave emitted by each of the points of a meshing (12) of the exterior surface of the structure of the aircraft and in which the zone (14) is defined by a subset (23) of the points of the meshing with characteristics closest to the characteristics of the measured signal.

8. Method according to Claim 7 including a preliminary step (210) of creating a reference database (22) in which reference database the characteristics of the signals received by each of the detectors Di are defined for each of the points of the meshing (12) considered as an emission source of an electromagnetic wave.

9. Method according to any one of the preceding claims including a step (256) of identification in graphical or digital form of the zone (14) on the exterior surface of the aircraft (10).

10. Assembly for locating on a structure (11) of an aircraft (10) at least one electrostatic discharge occurring in flight, said assembly including:

   - at least one recording system (50) onboard the aircraft, said recording system including:

      - a plurality of detectors **Di** intended to be arranged at different locations on an exterior surface of the structure of the aircraft;
      - means (52) for sampling electromagnetic signals (13) received by each detector of the plurality of detectors;
      - means (54) for time-stamping said electromagnetic signals received; and
      - means for permanently storing the sampled and time-stamped signals received by each of the detectors **Di**;

   - at least one analysis system (60) including means (61) for processing the signals recorded by the recording system (50), in which processing means one or more electromagnetic wave propagation digital models are used to determine a zone (14) of the exterior surface of the structure (11) of the aircraft in which said electrostatic discharge that has been identified probably occurred as being the origin of recorded signals, said signal processing means (61) of the analysis system (60) including a simulator incorporating inverse electromagnetic wave propagation algorithms and applying said inverse propagation algorithms to the signals (13), received by the detectors **Di,** in order to locate a zone (14), on the exterior surface of the structure (11) of the aircraft, from which said signals emitted by an electrostatic discharge stem, or including a simulator incorporating direct electromagnetic wave propagation algorithms and applying said algorithms in order to determine, by comparing between the recorded data, corresponding to the signals received by the detectors **Di,** and similar simulated data, a zone (14), on the exterior surface of the structure (11) of the aircraft, from which the signals emitted by an electrostatic discharge stem.

11. Assembly according to Claim 10 in which the recording system (50) includes hardware or software means (57) for synchronization of the time-stamps allocated to the signals received by the detectors, said synchronization means compensating differences of transmission time of the signals between the detectors and the recording means (51).

12. Assembly according to Claim 10 or Claim 11 in which at least one detector employs a radio antenna (16) of the aircraft to which is added an antenna coupler (56) connected on the one hand to an antenna cable intended for an equipment of the aircraft, for which said antenna is installed, and on the other hand to a transmission medium (53) connected to the recording means (51).

13. Asembly according to any one of Claims 10, 11 or 12 in which the recording system (50) includes digital connection means (58) for transfer of data with an installation on the ground to transfer the data recorded by said recording system to the analysis system (60).

14. Assembly according to any one of Claims 10 to 13 in which the processing means (61) of the analysis system (60) determine that recordings of signals received by the detectors Di may belong to one and the same event when the dates corresponding to said recordings are contained within a predefined time window, taking into account the dimensions of the aircraft.

15. Assembly according to any one of Claims 10 to 14 in which the processing means (61) of the analysis system (60) establish a signature through forms or intensities of a recorded signal that are received by a detector Di, the recordings of signals from various detectors corresponding to one and the same signature being considered to correspond to one and the same event.

16. Assembly according to any one of Claims 10 to 15 including a first system for construction of a reference database (22), said first system including a digital model (21) of the structure of the aircraft (10) on an exterior surface of which aircraft is defined a meshing (12) determining arbitrary origins of electromagnetic waves, said first system including a simulator incorporating the direct electromagnetic wave propagation algorithms, the reference database (22) including for each origin **Op** defined by the meshing (12) at least one item of information on the position of said origin on the exterior surface of the structure (11) of the aircraft and calculated characteristics of time or of shape of each of the signals received by each of the detectors **Di** following a simulated emission of an electromagnetic wave at the location of said origin.

17. Assembly according to any one of Claims 10 to 16 further including an aircraft in which is installed the system (50) for recording electromagnetic signals (13) emitted by electrostatic discharges on said aircraft.

18. Assembly according to Claim 16 or Claim 17 in which radio receive antennas (16) and/or radio navigation antennas of the aircraft are also used as the detectors **Di** of the recording system (50).

200

210

230

250

Fig. 1

210

212

E = .....

21

Di

10

Op

12

11

214

Op,Di

E

t

i= 1, N

p= 1, M

216

BdD

22

Fig. 2

230

232

13

Di  i=1, N

13  Di

10

Di  i=1,N  234

E

t

236

0

1

24

241

BdD

Fig. 3

250

252

D1

D2

⋮ DN

25

BdD

22

≈ ( Op Oq Or ⋮ Ot ) 23

254

11

10

14

256

Fig. 4

Fig. 6b

Fig. 6a

**Fig. 5**

**Fig. 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030071628 A
- US H536 A
- US 5923160 A
- US 6064340 A